(19) Europäisches Patentamt / European Patent Office / Office européen des brevets

(11) **EP 4 581 186 B1**

(12) **EUROPÄISCHE PATENTSCHRIFT**

(45) Veröffentlichungstag und Bekanntmachung des Hinweises auf die Patenterteilung:
**22.04.2026   Patentblatt 2026/17**

(21) Anmeldenummer: **24809615.8**

(22) Anmeldetag: **19.11.2024**

(51) Internationale Patentklassifikation (IPC):
*C23C 16/32* (2006.01)   *C23C 16/455* (2006.01)
*C23C 16/458* (2006.01)   *C30B 25/16* (2006.01)
*C30B 25/14* (2006.01)   *C30B 29/36* (2006.01)
*H01L 21/02* (2006.01)

(52) Gemeinsame Patentklassifikation (CPC):
**C23C 16/325; C23C 16/45508; C23C 16/45512; C23C 16/45574; C23C 16/4584; C30B 25/14; C30B 25/165; C30B 29/36; H10P 14/24; H10P 14/3408; H10P 14/3442**

(86) Internationale Anmeldenummer:
**PCT/EP2024/082792**

(87) Internationale Veröffentlichungsnummer:
**WO 2025/108916 (30.05.2025 Gazette 2025/22)**

(54) **VERFAHREN UND VORRICHTUNG ZUM ABSCHEIDEN N-DOTIERTEM SIC**

METHOD AND DEVICE FOR DEPOSITING N-DOPED SIC

PROCÉDÉ ET DISPOSITIF DE DÉPÔT DE SIC DOPÉ N

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **22.11.2023   DE 102023132597**

(43) Veröffentlichungstag der Anmeldung:
**09.07.2025   Patentblatt 2025/28**

(73) Patentinhaber: **AIXTRON SE**
**52134 Herzogenrath (DE)**

(72) Erfinder:
• **BOOKER, Pitsiri**
**52062 Aachen (DE)**
• **KÜPPERS, Philipp**
**52064 Aachen (DE)**
• **PFEFFER, Michael Ulrich**
**90762 Fürth (DE)**
• **SUBRAMANIAM, Dinesh Kanna**
**52074 Aachen (DE)**

(74) Vertreter: **Grundmann, Dirk et al**
**Rieder & Partner mbB**
**Patentanwälte - Rechtsanwalt**
**Yale-Allee 26**
**42329 Wuppertal (DE)**

(56) Entgegenhaltungen:
**US-A1- 2016 348 274   US-A1- 2020 043 725**

## Beschreibung

### Gebiet der Technik

Die Erfindung betrifft ein Verfahren zum Abscheiden einer SiC-Schicht auf einem Substrat in einer Prozesskammer eines CVD-Reaktors, wobei Wände der Prozesskammer mit einer Heizeinrichtung auf eine Prozesstemperatur aufgeheizt werden. Durch ein Gaseinlassorgan wird ein Prozessgasfluss in die Prozesskammer eingespeist. Der Prozessgasfluss durchströmt die Prozesskammer und überströmt die darin angeordneten Substrate in einer Horizontalrichtung. Der Prozessgasfluss enthält Wachstumsgasflüsse, die ein Silizium enthaltendes und ein Kohlenstoff enthaltendes reaktives Gas beinhalten. Der Prozessgasfluss enthält darüber hinaus Dotiergasflüsse, die gasförmige Dotierstoffträger enthalten. Die Kohlenstoff und Stickstoff enthaltenden reaktiven Gase zerlegen sich bei der Prozesstemperatur in der Prozesskammer beziehungsweise auf Oberflächen der aufgeheizten Wände der Prozesskammer sowie auf der Substratoberfläche. Die Zerlegungsprodukte der reaktiven Gase scheiden sich als einkristalline Schicht auf dem Substrat ab. Ebenso zerlegen sich die Dotierstoffträger in der Prozesskammer beziehungsweise an Oberflächen der Wände der Prozesskammer oder auf der Substratoberfläche. Die Zerlegungsprodukte der Dotierstoffträger werden als Dotierstoff in die SiC-Schicht eingebaut. Bevorzugt führt der Dotierstoff zu einer n-dotierten Schicht. Der Dotierstoff ist bevorzugt Stickstoff.

### Stand der Technik

Bei einem anderen Verfahren des Standes der Technik, das in der DE 10 2011 054 566 A1 beschrieben wird, nämlich beim Abscheiden von GaN-Schichten heizt sich das aus dem kalten Gaseinlassorgan austretende Prozessgas zunächst in einer Vorlaufzone auf. In dieser Phase findet parasitäres Wachstum auf der Oberfläche der Vorlaufzone statt. Während des Überströmens des Substrates vermindert sich die Konzentration beziehungsweise der Partialdruck der reaktiven Gase in dem durch die Prozesskammer strömenden Trägergasfluss. Dies führt zu einer in Strömungsrichtung des Prozessgases fortschreitenden Verarmung. Dies hat zur Folge, dass die Wachstumsrate der Schicht beziehungsweise der Transport des Dotierstoffs aus der Gasphase in Richtung auf die Substratoberfläche in Strömungsrichtung stetig abnimmt. Wird das Substrat während des Abscheidens um eine Vertikalachse gedreht, kann dieser Effekt kompensiert werden. Verläuft die Verarmungskurve oberhalb des Substrates auf einer in Strömungsrichtung abfallenden Geraden, so kann trotzdem eine Schicht mit einer homogenen Schichtdicke abgeschieden werden.

In der Realität verläuft die Verarmungskurve aber nicht auf einer idealen Geraden, sondern entlang einer gekrümmten Kurve. Die oben genannte DE 10 2011 054 566 A1 beschreibt ein Verfahren, bei dem verschiedene reaktive Gase durch ein im Zentrum der Prozesskammer angeordnetes Gaseinlassorgan durch vertikal übereinander angeordnete Gaseinlasszonen in die Prozesskammer eingespeist werden. Die Partialdrucke der verwendeten reaktiven Gase vermindern sich aufgrund des oben beschriebenen Verarmungseffektes entlang nicht geradlinig verlaufender Verarmungskurven. Durch eine geeignete Mischung der reaktiven Gase, die durch voneinander verschiedene Gaseinlasszonen strömen, kann ein laterales Profil der Schichtdicke beeinflusst werden.

Die US 2020/0043725 A1 beschreibt eine Vorrichtung und ein Verfahren zum Abscheiden von n-dotiertem SiC, wobei als Dotierstoff $NH_3$ und $N_2$ verwendet wird.

Die US 2016/0348274 A1 offenbart ein Verfahren zur Abscheidung einer dotierten SiC-Schicht auf einem drehangetriebenen Substrat in einem CVD-Reaktor mit horizontaler Strömungsrichtung mit nur einem Dotiergasträger, der Ammoniak ist. Der Dotiergasträger Ammoniaks wird getrennt von weiteren Prozessgasen in eine obere Gaseinlasszone vertikal oberhalb einer unteren Gaseinlasszone in die Prozesskammer des CVD-Reaktors eingespeist, um die Bildung von Ammoniumchlorid in der Gasphase zu verhindern.

In der JP 2015-143168 A wird ein Verfahren beschrieben, bei dem ein Prozessgas, das eine Siliziumverbindung und eine Kohlenstoffverbindung sowie $NH_3$ enthält, in eine allseitig beheizte Prozesskammer eingespeist wird. Die Oberflächen der Wände der Prozesskammer sind mit SiC beschichtet. Auf einem sich um eine Drehachse drehenden Substrat wird mittels $NH_3$ als Dotierstoffträger n-dotiertes SiC abgeschieden. Der Partialdruck der Bestandteile des Prozessgases verringert sich stetig in Strömungsrichtung.

Aus der Veröffentlichung "Experimental Study of the Pyrolysis of NH3 under Flow Reactor Conditions, Mario Benes, et al, 2021 American Chemical Society, p 7193" ist es bekannt, dass sich bei hohen Temperaturen auf SiC-Oberflächen aus Ammoniak, Methan oder Ethan, Trichlorsilan und Wasserstoff Zwischenprodukte bilden, die Stickstoff enthalten, beispielsweise HCN oder $Si_3N$.

Die WO 2022/053963 A1 beschreibt ein ähnliches Verfahren zum Abscheiden von n-dotiertem SiC.

Die oben beschriebene Verarmung findet bei der Verwendung von $N_2$ als Dotierstoffträger nicht statt. $N_2$ reagiert allerdings katalytisch an der Oberfläche der Prozesskammer und insbesondere in der unmittelbaren Umgebung des Substrates beziehungsweise an der Oberfläche einer zwischen Gaseinlassorgan und Substrat liegenden Vorlaufzone. Hier kann sich HCN bilden. Die Menge des HCN, das zum Substrat gelangt, hängt im Wesentlichen mit der Geometrie der Vorlaufzone und insbesondere der dort angeordneten Abdeckplatte sowie deren Oberfläche ab. Als Folge dessen ist beim Abscheiden von stickstoffdotiertem SiC eine Überhöhung des Dotierstoffeinbaus im Bereich des Randes des sich beim Abscheiden drehenden Substrates zu beobachten. Die Dotierstoffverteilung in der abgeschiedenen SiC-Schicht hängt somit von der Konzentration von $N_2$, HCN und dem Kohlenstoff enthaltenden reaktiven Gas in der Gasphase ab.

**Zusammenfassung der Erfindung**

Der Erfindung liegt die Aufgabe zugrunde, die Dotierstoffhomogenität beim Abscheiden von n-dotiertem SiC zu verbessern und insbesondere in einem CVD-Reaktor, bei dem ein Gaseinlassorgan von zu beschichtenden Substraten umgeben ist, die gleichzeitig mit einer SiC-Schicht beschichtet werden.

Die Aufgabe wird durch das in den Ansprüchen angegebene Verfahren beziehungsweise die beanspruchte Vorrichtung gelöst. Die Unteransprüche stellen nicht nur vorteilhafte Weiterbildungen der in den nebengeordneten Ansprüchen angegebenen technischen Lehren dar, sondern sind auch eigenständige Lösungen der Aufgabe.

Zunächst und im Wesentlichen wird vorgeschlagen, den Prozessgasfluss auf mehrere vertikal übereinander angeordnete Gaseinlasszonen aufzuteilen und die Paarung der verschiedenen Dotierstoffträger so zu wählen, dass der Dotierstoffträger des ersten Dotiergasflusses ein laterales Dotierungsprofil in einer SiC-Schicht erzeugt, das insbesondere am Rand des Substrates einen anderen Verlauf hat, als ein laterales Dotierungsprofil, das vom Dotierstoffträger des zweiten Dotiergasflusses in der SiC-Schicht erzeugt wird. So kann insbesondere vorgesehen sein, dass das vom ersten Dotiergasfluss erzeugte laterale Dotierungsprofil eine zum Rand des Substrates hinabfallende Dotierstoffkonzentration aufweist und das zweite laterale Dotierungsprofil eine zum Rand des Substrates hin ansteigende Dotierstoffkonzentration aufweist. Durch geeignete Wahl der Dotiergasflüsse, also der Massenflüsse der Dotierstoffträger in die Prozesskammer, kann ein überlagertes Dotierungsprofil erzeugt werden,

das sowohl vom ersten Dotierstoffträger als auch vom zweiten Dotierstoffträger erzeugt wird. Es bildet sich ein Summenprofil. Die Randüberhöhung, die von einem Dotiergasfluss erzeugt wird, kann durch eine Randverminderung des Summenprofils durch den anderen Dotiergasfluss kompensiert werden. Beispielsweise kann einer der Dotiergasflüsse ein auf einer durch eine diametrale Linie durch das Substrat gemessenes Dotierstoffprofil erzeugen, welches A-, U-, V- oder W-förmig ist. Der andere der Dotiergasflüsse kann ein diesem Dotierstoffprofil entgegengerichtetes Dotierstoffprofil erzeugen, welches beispielsweise die Form eines auf dem Kopf stehenden A, U, V oder W entspricht. Die unterschiedlichen Dotierstoffträger werden insbesondere durch voneinander verschiedene Gaseinlasszonen in die Prozesskammer eingespeist, wobei sich die Gaseinlasszonen auf unterschiedlichen vertikalen Niveaus befinden. Der Dotierstoffträger eines ersten Dotiergasflusses kann beispielsweise ein in der Mitte nach oben gekrümmtes Dotierungsprofil erzeugen. Der Dotierstoffträger eines zweiten Dotiergasflusses kann beispielsweise ein in der Mitte nach unten gekrümmtes Dotierungsprofil erzeugen. Durch eine geeignete Mischung der beiden Dotiergasflüsse kann ein effektives Dotierungsprofil eingestellt werden.

Die Dotierstoffträger sind bevorzugt Gase, die Stickstoff enthalten. Beispielsweise kann der erste Dotierstoffträger $NH_3$ und der zweite Dotierstoffträger $N_2$ sein. Es ist insbesondere bevorzugt, dass die Stickstoffatome in den Molekülen der Dotierstoffträger mit unterschiedlich starken Bindungskräften an die übrigen Atome der Moleküle gebunden sind. So kann vorgesehen sein, dass bei einem Dotierstoffträger der Stickstoff mit einer Einfachbindung an die übrigen Moleküle gebunden ist und bei einem anderen Dotierstoffträger der Stickstoff in einer Zweifach- oder Dreifachbindung an die übrigen Moleküle gebunden ist. Es ist insbesondere vorgesehen, dass die verwendeten Dotierstoffträger mit voneinander verschiedenen Reaktionsgeschwindigkeiten an der Oberfläche des Substrates, an der Oberfläche der Vorlaufzone und/oder mit den Wachstumsgasen reagieren.

Es kann ferner vorgesehen sein, dass ein $NH_3$ enthaltender Dotiergasfluss nicht durch dieselbe Gaseinlasszone strömt, durch die ein Moleküle mit dem Element Chlor enthaltender Wachstumsgasfluss, beispielsweise Trichlorsilan, strömt. Ein anderer Wachstumsgasfluss kann Moleküle mit dem Element Kohlenstoff enthalten, beispielsweise Methan oder Ethen. Der Wachstumsgasfluss kann aber auch Dichlorsilan enthalten. In diesem Fall kann zusätzlich HCl in die Prozesskammer eingespeist werden.

Als Dotierstoffträger kommen insbesondere die folgenden Stickstoffverbindungen in Betracht: $N_2$, $NH_3$ HCN, Pyridin ($C_5H_5N$), Hydrazin ($N_2H_4$), Dimethylhydrazin ($C_2H_8N_2$) oder unsymmetrisches Dimethylhydrazin.

Gemäß einer bevorzugten Variante des Verfahrens enthält der durch zumindest drei vertikal übereinander angeordnete Gaseinlasszonen in die Prozesskammer eingespeiste Prozessgasfluss zwei voneinander verschiedene Dotiergasflüsse, die durch unterschiedliche Gaseinlasszonen eingespeist werden. Die Dotiergasflüsse können jeweils zusammen mit einem Wachstumsgasfluss, also einem Moleküle mit dem Element Kohlenstoff enthaltenden oder einem Moleküle mit dem Element Silizium enthaltenden Gas durch dieselbe Gaseinlasszone in die Prozesskammer eingespeist werden. Es sind insbesondere genau drei vertikal übereinander angeordnete Gaseinlasszonen vorgesehen, nämlich eine zuoberst angeordnete, eine zuunterst angeordnete und eine in der Mitte angeordnete Gaseinlasszone. Es können aber auch weitere Gaseinlasszonen vorgesehen sein.

Gemäß einer Variante der Erfindung wird ein erster Dotiergasfluss durch eine zuoberst angeordnete Gaseinlasszone und ein zweiter Dotiergasfluss in eine tiefer liegende Gaseinlasszone eingespeist. Eine weitere Variante sieht vor, dass der erste Dotiergasfluss zusammen mit einem ersten Wachstumsgasfluss durch dieselbe Gaseinlasszone fließt. Dabei kann vorgesehen sein, dass $NH_3$ zusammen mit $C_2H_4$ durch dieselbe Gaseinlasszone fließt. In einer weiteren Variation kann vorgesehen sein, dass der zweite Dotiergasfluss, also beispielsweise $N_2$, zusammen mit einem zweiten Wachstumsgasfluss, beispielsweise einem Moleküle mit dem Element Silizium enthaltenden Wachstumsgasfluss, beispielsweise $HCl_3Si$, in die Prozesskammer eingespeist wird. Eine weitere Variante sieht vor, dass durch eine zuunterst angeordnete Gaseinlasszone ein dritter Wachstumsgasfluss fließt, der insbesondere Moleküle mit dem Element Kohlenstoff enthält. Es kann vorgesehen sein, dass durch alle Gaseinlasszonen ein Moleküle mit dem Element Kohlenstoff enthaltender Wachstumsgasfluss fließt und nur durch eine mittlere Gaseinlasszone ein Moleküle mit dem Element Silizium enthaltender und insbesondere ein Moleküle mit dem Element Chlor enthaltender Wachstumsgasfluss fließt. Es kann auch vorgesehen sein, dass durch die zuunterst liegende Gaseinlasszone oder dass durch die zuoberst liegende Gaseinlasszone kein Dotiergasfluss fließt. Es kann auch vorgesehen sein, dass sich die Dotierstoffträger der verschiedenen Dotiergasflüsse nicht unterscheiden. In diesem Falle werden die verschiedenen Dotiergasflüsse durch voneinander verschiedene Gaseinlasszonen eingespeist. Die vertikale Höhe der Gaseinlasszone beeinflusst die Form des Dotierungsprofils, sodass allein durch die Wahl der Gaseinlasszone das Dotierungsprofil beeinflusst werden kann. Hierbei ist insbesondere vorgesehen, dass die beiden Dotiergasflüsse durch die am weitesten vertikal voneinander entfernten Gaseinlasszonen in die Prozesskammer eingespeist werden, beispielsweise kann durch eine zuoberst angeordnete Gaseinlasszone $NH_3$ und eine zuunterst angeordnete Gaseinlasszone ebenfalls $NH_3$ in die Prozesskammer eingespeist werden. Durch die dazwischen liegenden Gaseinlasszonen fließt bevorzugt kein Dotiergasfluss.

Die erfindungsgemäße Vorrichtung besitzt einen CVD-Reaktor und eine Gasmischeinrichtung sowie eine Steuereinrichtung. Die Gasmischeinrichtung besitzt Vorratsbehälter für die reaktiven Gase, die Silizium und Kohlenstoff enthalten. Sie besitzt ferner Vorratsbehälter für den zumindest einen Dotierstoffträger, bevorzugt aber Vorratsbehälter für mindestens zwei Dotierstoffträger. Die Gasmischeinrichtung besitzt darüber hinaus Massenflusscontroller und Ventile, um die reaktiven Gase und die Dotierstoffträger in geeigneter Weise als Wachstumsgasflüsse und Dotiergasflüsse auf die vertikal übereinander angeordneten Gaseinlasszonen des Gaseinlassorgans aufzuteilen. Die Massenflusscontroller und die Ventile werden von der Steuereinrichtung nach einem Steuerprogramm gesteuert. Die reaktiven Gase werden zusammen mit $H_2$ in die Gaseinlasszonen eingespeist.

Der CVD-Reaktor besitzt ein Gaseinlassorgan. Letzteres ist im Zentrum einer Prozesskammer angeordnet. Das Gaseinlassorgan ist von einem Suszeptor umgeben, der auf einer Kreisbogenlinie um das Zentrum des Gaseinlassorgans angeordnete Substratträger aufweist. Die Substratträger können kreisscheibenförmige Körper sein, die jeweils in einer Tasche einer nach oben weisenden Oberfläche des Suszeptors einliegen. In den Boden der Taschen mündet jeweils eine Gaszuleitung, durch die ein Spülgas in die Tasche eingespeist wird, sodass der Substratträger angehoben, auf einem Gaskissen schwebend gedreht wird. Auf dem Substratträger kann zumindest ein Substrat angeordnet sein, das während des Abscheidens der SiC-Schicht um eine Vertikalachse gedreht wird. Der Suszeptor kann sich um eine zentrale Achse drehen. Der Suszeptor und eine dem Suszeptor gegenüberliegende Prozesskammerdecke können aus Graphit gefertigt sein. Die Oberfläche dieser Graphitteile ist beschichtet und insbesondere mit SiC oder TaC beschichtet. Das Gaseinlassorgan kann ebenfalls aus Graphit gefertigt sein. Bevorzugt ist das Gaseinlassorgan aber aus Quarz, Stahl (Edelstahl) oder einem keramischen Material gefertigt. Die Oberfläche des Suszeptors kann auch mit Abdeckplatten belegt sein, die aus Graphit, insbesondere mit SiC oder TaC beschichtetem Graphit oder aus SiC oder TaC bestehen. Die Substratträger können aus demselben beschichteten oder unbeschichteten Graphit-Material bestehen. Die Prozesskammerdecke kann von einem Träger getragen werden. Dieser kann aus einem anderen Werkstoff bestehen.

Im Folgenden wird ein Verfahren zur Ermittlung von Massenflusswerten der Dotiergasflüsse beschrieben, mit denen sich ein möglichst flaches laterales Profil der Dotierstoffkonzentration in einer Schicht erzeugen lässt. Hierzu wird vorgeschlagen, dass in einer Prozesskammer des CVD-Reaktors auf einem Substrat eine erste Schicht abgeschieden wird. Bei dem Abscheiden der ersten Schicht wird zusätzlich zu den Wachstumsgasflüssen nur einer der Dotiergasflüsse, beispielsweise $NH_3$ in die Prozesskammer eingespeist. Es kann vorgesehen sein, dass in diesem Prozessschritt eine Optimierung vorgenommen wird derart, dass der Massenfluss des ersten Dotiergasflusses bzw. die Massenflüsse der Wachstumsgasflüsse variiert werden. Die Variierung erfolgt mit dem Ziel, in der Schicht ein laterales Profil der Dotierstoffkonzentration zu erzeugen, das möglichst flach verläuft.

Ein Kriterium für ein möglichst flach verlaufendes laterales Profil kann beispielsweise die Summe der Abstandsquadrate von Differenzen von an verschiedenen Radialpositionen gemessenen Dotierstoffkonzentrationen von einem Mittelwert sein. Diese Summe soll ein Minimum besitzen.

In einem darauf folgenden Schritt wird ein zweites laterales Profil ermittelt. Auf einem Substrat wird in der Prozesskammer eine zweite Schicht abgeschieden.

Dabei werden wiederum vorgegebene Wachstumsgasflüsse in die Prozesskammer eingespeist. Bevorzugt handelt es sich dabei um dieselben Wachstumsgasflüsse, die auch im ersten Schritt verwendet werden, insbesondere um die Wachstumsgasflüsse, die sich durch die Optimierung des ersten lateralen Profils ergeben haben. Im zweiten Schritt wird allerdings ein anderer Dotiergasflusses in die Prozesskammer eingespeist, nämlich insbesondere der zweite Dotiergasfluss.

An den beiden Schichten, die auf zwei voneinander verschiedenen Substraten abgeschieden worden sind, werden dann Messungen der Dotierstoffkonzentration innerhalb der Schichten vorgenommen. Es werden an voneinander verschiedenen radialen Positionen Messwerte gewonnen. Es können auf einer Kreisbogenlinie um das Zentrum des Substrates verschiedene Messungen vorgenommen werden. Aus diesen Messungen kann ein Mittelwert gebildet werden.

Aus den Messwerten, insbesondere den jeweiligen Mittelwerten von Dotierstoffkonzentrationen an verschiedenen Radialpositionen werden dann Effizienzwerte E1, E2 wie folgt berechnet:

$$E1(R) = n1(R) \,/\, D1; \; E2(R) = n2(R) \,/\, D2$$

wobei n1(R) und n2(R) jeweils eine Dotierstoffkonzentration an einer Radialposition R ist.

Mithilfe der Effizienzwerte E1, E2 kann dann eine Optimierung vorgenommen werden, in dem die erwartete Dotierstoffkonzentration n(R) in einer Schicht berechnet wird, wenn alle Dotiergasflüsse verwendet werden

$$n(R) = (E1'/D1') + (E2'/D2')$$

wobei D1', D2' zu optimierende Dotiergasflüsse sind. Bei der Optimierung werden die Dotiergasflüsse D1', D2' derart variiert, dass sich ein möglichst flaches drittes laterales Profil der Dotierung ausbildet.

**Kurze Beschreibung der Zeichnungen**

Im Folgenden wird die Erfindung anhand von Ausführungsbeispielen näher erläutert. Es zeigen:

Fig. 1    schematisch in der Art eines Halbschnitts gemäß der Linie I-I in Figur 2 einen CVD-Reaktor 1,

Fig. 2    den Schnitt gemäß der Linie II in Figur 1,

Fig. 3    schematisch eine Vorrichtung zum Abscheiden von SiC-Schichten mit einem Gasmischsystem und einem CVD-Reaktor,

Fig. 4    ein Diagramm, welches oben zwei Dotierstoffprofile durch eine SiC-Schicht und unten jeweils zwei Dotierstoffprofile zeigt, die von unterschiedlichen Dotierstoffträgern erzeugt werden,

Fig. 5    eine schematische Darstellung eines zweiten Ausführungsbeispiels hinsichtlich der Zusammensetzung und Aufteilung des Prozessgasflusses,

Fig. 6    eine Darstellung gemäß Figur 5 eines dritten Ausführungsbeispiels,

Fig. 7    eine Darstellung gemäß Figur 5 eine vierten Ausführungsbeispiels, und

Fig. 8    eine Darstellung von durch Experimente ermittelten lateralen Dotierstoffprofilen a, b und einem berechneten Dotierstoffprofil.

**Beschreibung der Ausführungsformen**

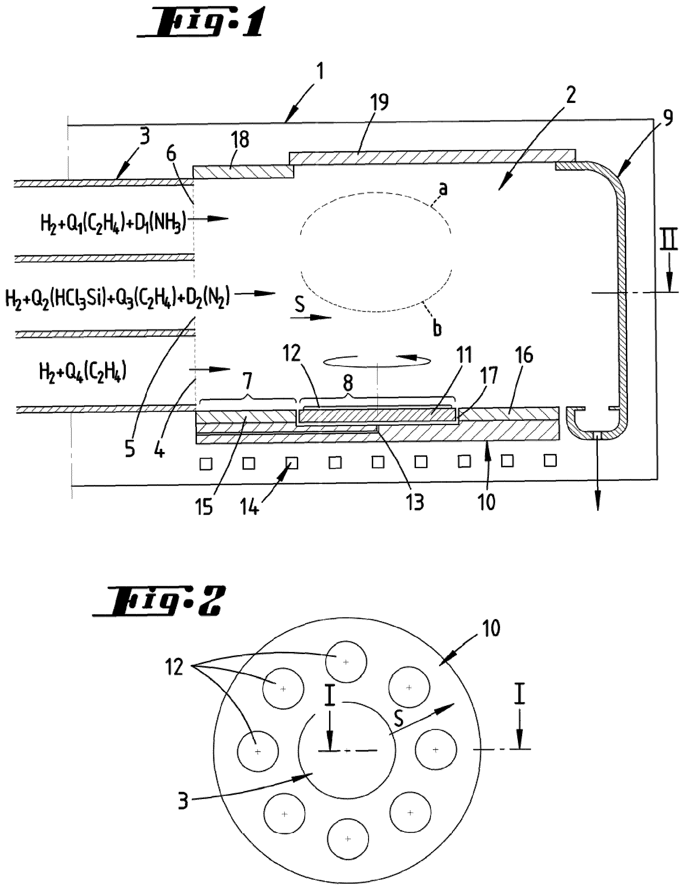

Die Figuren 1 und 2 zeigen schematisch den Aufbau eines CVD-Reaktors 1. In einem Gehäuse des CVD-Reaktors 1, das aus Edelstahl bestehen kann, befindet sich ein Suszeptor 10, der aus Graphit bestehen kann und dessen Oberfläche mit SiC beschichtet sein kann. Der Suszeptor kann um eine zentrale Achse drehangetrieben werden. Der Suszeptor besitzt die in der Figur 2 dargestellte Kreisscheibenform.

Oberhalb des Suszeptors 10 befindet sich eine Prozesskammer 2, die nach oben hin von einer Prozesskammerdecke begrenzt wird. Die Prozesskammerdecke wird von einer Deckenplatte 19 gebildet, die sich auf einem Halteelement 18 abstützen kann. Die Deckenplatte 19 kann sich auch auf einem um den Suszeptor 10 herum angeordneten Gasauslassorgan 9 abstützen. Die Deckenplatte 19 kann aus mit SiC beschichtetem Graphit bestehen. Das Gasauslassorgan 9 kann ebenfalls aus diesem Material bestehen. Es kann aber auch aus einem keramischen Material gefertigt sein.

Der Suszeptor 10 ist mit Abdeckplatten 15, 16 belegt, die ebenfalls aus SiC-beschichtetem Graphit bestehen können. Sie können aber auch aus SiC bestehen. Es bilden sich Taschen 17 aus, die einen Taschenboden aufweisen, in den eine Gaszuleitung 13 mündet. Mit dem aus der Gaszuleitung 13 strömenden Spülgas, beispielsweise Wasserstoff, kann ein sich drehendes Gaskissen erzeugt werden, das einen Substrathalter 11, der ebenfalls aus SiC-beschichtetem oder unbeschichtetem Graphit bestehen kann, in einer Schwebe hält und den Substrathalter 11 um eine Drehachse drehantreibt.

Unterhalb des Suszeptors 10 ist eine Heizeinrichtung 14 vorgesehen, bei der es sich um eine RF-Heizung handeln kann, mit der der Suszeptor 10 beheizt wird. Es kann darüber hinaus eine nicht dargestellte weitere Heizeinrichtung vorgesehen sein, um die Prozesskammerdecke, also die Deckenplatte 19, aufzuheizen, sodass die Prozesskammer 2 von allen Seiten beheizt wird. Bevorzugt wird die Deckenplatte 19 aber nicht aktiv beheizt. Die Deckenplatte 19 wird passiv über Wärmestrahlung vom Suszeptor 10 beziehungsweise von den Abdeckplatten 15, 16 beheizt, sodass die Oberflächentemperatur der Deckenplatte 19 wesentlich niedriger ist, als die Oberflächentemperatur der Abdeckplatten 15, 16. Dies hat zur Folge, dass an der Deckenplatte 19 andere Oberflächenreaktionen stattfinden als auf den Abdeckplatten 15, 16 beziehungsweise auf den Suszeptor 10. Die eingangs erwähnten, bei der Zerlegung von NH3 oder N2 entstehenden Zwischenprodukte können somit in einem verminderten Umfang im oberen Bereich der Prozesskammer 2 entstehen. Dies kann auch das Dotierungsprofil beeinflussen.

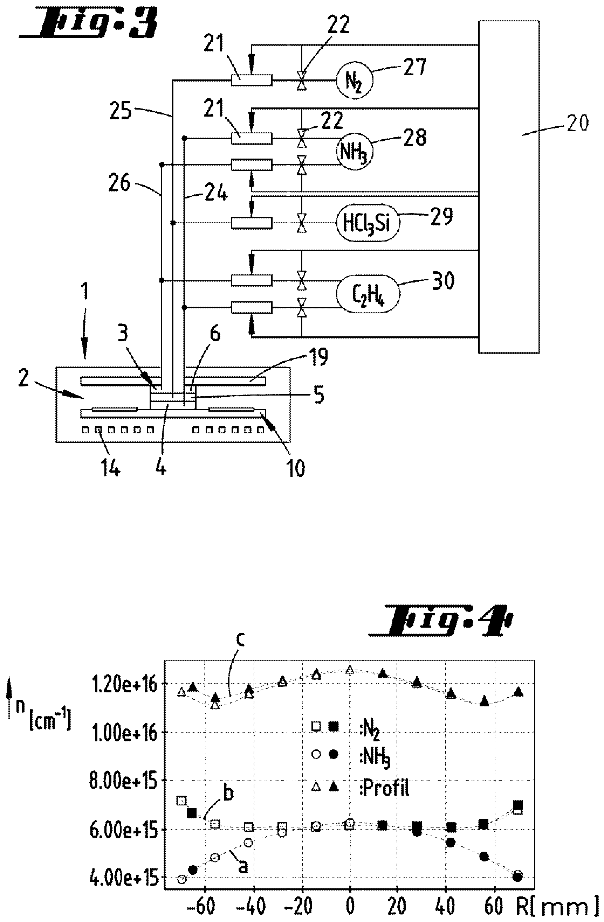

In der Mitte der Prozesskammer 2 befindet sich ein Gaseinlassorgan 3, welches aus einem keramischen Material, aus Edelstahl, aus Quarz oder aus einem SiC-beschichteten Graphit bestehen kann. Das Gaseinlassorgan 3 bildet drei (siehe Figur 3) übereinander angeordnete Gaseinlasszonen 4, 5, 6 aus, die jeweils mit einer Zuleitung 24, 25, 26 verbunden sind, durch die jeweils Teile eines Prozessgasflusses in die jeweilige Gaseinlasszone 4, 5, 6 eingespeist werden können. Der Prozessgasfluss wird in einem Gasmischsystem bereitgestellt, das eine Gasquelle 27 für Stickstoff, eine Gasquelle 28 für Ammoniak, eine Gasquelle 29 für Trichlorsilan und eine Gasquelle 30 für Ethen ($C_2H_4$) besitzt. Es kann auch eine Gasquelle für HCl vorgesehen sein.

In einem nicht dargestellten Ausführungsbeispiel besitzt das Gaseinlassorgan 3 beispielsweise vier oder fünf oder mehr übereinander angeordnete Gaseinlasszonen.

Jede der Gasquellen 27 bis 30 ist mit Ventilen 22 und Massenflusscontrollern 21 mit zumindest einer der Zuleitungen 24, 25, 26 verbunden. Die Massenflusscontroller 21 und die Ventile 20 werden nach einem Programm der Steuereinrichtung 20 gesteuert.

Mit dem Gasmischsystem werden zumindest zwei Dotiergasflüsse D1, D2 bereitgestellt, die jeweils einen Dotierstoffträger aufweisen, beispielsweise $N_2$ oder $NH_3$ oder eine der oben genannten weiterhin verwendbaren Stickstoffverbindungen. Mit dem Gasmischsystem werden darüber hinaus zumindest zwei Wachstumsgasflüsse Q1, Q2 bereitgestellt, bevorzugt aber mehrere Wachstumsgasflüsse Q1, Q2, Q3, Q4, Q5. Die Wachstumsgasflüsse enthalten Kohlenstoff und Silizium. Eines dieser Gase kann auch Chlor enthalten, beispielsweise Trichlorsilizium, Dichlorsilizium oder HCl.

Die Dotiergasflüsse D1, D2 und gegebenenfalls D3 oder D4 werden durch die voneinander verschiedenen und vertikal übereinander angeordneten Gaseinlasszonen 4, 5, 6 zusammen mit den mehreren Wachstumsgasflüsse Q1 bis Q5 in die Prozesskammer 2 eingespeist. Der sich derart zusammensetzende Prozessgasfluss durchströmt zunächst eine Vorlaufzone 7 der Prozesskammer 2, die von der Heizeinrichtung 14 oder einer weiteren, oben angeordneten und nicht dargestellten Heizeinrichtung beheizt wird. In dieser Vorlaufzone 7 wird das Prozessgas, das insbesondere Wasserstoff als Trägergas beinhalten kann, auf eine Prozesstemperatur aufgeheizt.

Zum Ende der Vorlaufzone 7 erreichen die Dotiergasflüsse D1, D2, D3, D4 und die Wachstumsgasflüsse Q1 bis Q5 eine Temperatur, bei der sich die Bestandteile der Dotiergasflüsse und der Wachstumsgasflüsse zerlegen beziehungsweise miteinander reagieren können. Die Bestandteile der Dotiergasflüsse und der Wachstumsgasflüsse können darüber hinaus katalytisch an den Oberflächen der Abdeckplatten 15 oder der Deckenplatte 19 reagieren. Dabei bilden sich Zwischenprodukte und insbesondere Zerlegungsprodukte. Die Zwischen- oder Zerlegungsprodukte und gegebenenfalls unzerlegte Dotierstoffträger (beispielsweise $N_2$) wandern aus der Gasphase oberhalb des Substrathalters 11 in einer Depositionszone 8 in Richtung der Oberfläche eines auf dem Substrathalter 11 aufliegenden, drehenden Substrates 12. Dies erfolgt im Wesentlichen durch Diffusion aufgrund einer durch die Kondensation beziehungsweise Konsumption der Zwischen- oder Zerlegungsprodukte auf der Substratoberfläche 12 verursachten Verarmung der Gasphase.

Wegen dieses Konsums des Si, C und N an der Oberfläche des Substrates 12 beziehungsweise der dort abgeschiedenen n-dotierten SiC-Schicht vermindert sich der Partialdruck des Wachstumsgases und des Dotierstoffträgers in der Gasphase oberhalb des Substrates 12. Die Figur 1 zeigt schematisch zwei Dotierungsprofile a und b, die über einen Durchmesser des Substrates 2 gemessen werden. Die als gekrümmte Linien dargestellten linearen Dotierungsprofile a und b sind rotationssymmetrisch und stellen einen Schnitt durch das laterale Dotierungsprofil in der auf dem Substrat 12 abgeschiedenen Schicht dar.

Das Dotierungsprofil a wird in einer auf dem Substrat 11 abgeschiedenen SiC-Schicht erzeugt, wenn das Substrat 11 während des Abscheidens gedreht wird und nur der erste Dotiergasfluss D1 durch die Gaseinlasszone 6 in die Prozesskammer 2 eingespeist wird. Das Dotierstoffprofil b wird in einer auf dem Substrat 11 abgeschiedenen SiC-Schicht erzeugt, wenn das Substrat 11 während des Abscheidens gedreht wird und nur der zweite Dotiergasflusses D2 durch die Gaseinlasszone 5 in die Prozesskammer 2 eingespeist wird.

Beim Ausführungsbeispiel ist der Dotierstoffträger des ersten Dotiergasflusses D1 $NH_3$ und der Dotierstoffträger des zweiten Dotiergasflusses D2 $N_2$. Es ist ersichtlich, dass die beiden Dotierungsprofile nicht geradlinig verlaufen, sondern gekrümmt sind. Die Auswahl der Dotierstoffträger beziehungsweise die Auswahl der Gaseinlasszonen 4, 5, 6, durch die der jeweilige Dotiergasfluss D1, D2 strömt, erfolgt derart, dass sich zwei Dotierungsprofile a, b ausbilden, die in entgegengesetzter Richtung gekrümmt sind. Beispielsweise ist im Ausführungsbeispiel das Dotierungsprofil a nach oben hin und das Dotierungsprofil b nach unten hin gekrümmt. Durch eine Variation der Massenflüsse der beiden Dotiergasflüsse D1, D2 kann ein Dotierungsprofil eingestellt werden, das nahezu geradlinig verläuft. Ein geradlinig verlaufendes Dotierungsprofil hat bei einem drehangetriebenen Substrat 12 die Folge, dass sich eine nahezu homogene Dotierstoffverteilung in der auf dem Substrat 12 abgeschiedenen SiC-Schicht ausbildet.

Die Wahl der Dotierstoffträger und die Wahl der Gaseinlasszonen 4, 5, 6, durch die die Dotierstoffträger in die Prozesskammer eingespeist werden, kann so vorgenommen werden, dass das inhomogene rotationssymmetrische Dotierungsprofil, welches durch einen Dotierstoffträger erzeugt wird, durch das ebenfalls inhomogene rotationssymmetrische Dotierungsprofil, welches durch einen anderen Dotierstoffträger erzeugt wird, in Richtung eines homogenen rotationssymmetrischen Summenprofils kompensiert wird. Ein Dotierungsprofil kann beispielsweise U-förmig sein. Das andere Dotierungsprofil kann die Form eines invertierten U sein.

Bei dem in der Figur 1 dargestellten ersten Ausführungsbeispiel wird in die zuunterst angeordnete Gaseinlasszonen 4 Wasserstoff und ein vierter Wachstumsgasfluss Q4 eingespeist, welcher $C_2H_4$ ist. Der Massenfluss des vierten Wachstumsgasflusses Q4 entspricht etwa 10% der Summe aller Kohlenstoff enthaltenden Wachstumsgasflüsse Q1 + Q3 + Q4. In der mittleren Gaseinlasszone 5 wird zusätzlich zu Wasserstoff ein dritter Wachstumsgasfluss Q3 eingespeist, der $C_2H_4$ enthält und ein zweiter Wachstumsgasfluss Q2, der $HCl_3SI$ enthält. Der dritte Wachstumsgasfluss Q3 enthält etwa 80% der Summe aller Kohlenstoff enthaltenden Wachstumsgasflüsse. Zusätzlich wird durch die mittlere Gaseinlasszone 5 ein zweiter Dotiergasfluss D2 eingespeist, der Stickstoff ist. Durch die zuoberst liegende Gaseinlasszone 6 wird Stickstoff sowie ein erster Wachstumsgasfluss Q1, der $C_2H_4$ enthält, eingespeist. Der Massenfluss dieses Wachstumsgasflusses Q1 entspricht etwa 10% der Summe aller Kohlenstoff enthaltenden Wachstumsgasflüsse. Zusätzlich wird durch die zuoberst angeordnete Gaseinlasszone 6 auch ein erster Dotiergasfluss D1 eingespeist, der $NH_3$ enthält.

Die Figur 4 beschreibt den Effekt, den die Einspeisung verschiedener Dotiergasflüsse D1, D2 durch auf verschiedenen Niveaus angeordneten Gaseinlasszonen 5, 6 auf die Dotierstoffverteilung innerhalb der abgeschiedenen Schicht hat. Die oberen als offene und als geschlossene Dreiecke dargestellten Kurve c zeigt einen Schnitt durch den Mittelpunkt einer auf dem Substrat 12 abgeschiedenen Schicht und die Dotierstoffverteilung in der Schicht, die nahezu gleichmäßig verläuft. Lediglich im randnahen Bereich der Schicht des kreisscheibenförmigen Substrates 12 ist eine geringfügige Verminderung der Dotierstoffkonzentration zu beobachten.

Die beiden unteren Kurven a, b zeigen den Dotierstoffeinbau, den nur eines der beiden voneinander verschiedenen Dotierstoffträger erzeugen würde. Mit den offenen und geschlossenen Quadraten (Kurve b) ist der Dotierstoffeinbau dargestellt, den nur $N_2$ bewirken würde. Bei der Verwendung von ausschließlich $N_2$ als Dotierstoffträger wird eine starke Randüberhöhung des Dotierstoffeinbaus beobachtet. Mit den offenen und geschlossenen Kreisen (Kurve a) ist der Dotierstoffeinbau dargestellt, den nur $NH_3$ bewirken würde. Bei der Verwendung von ausschließlich $NH_3$ als Dotierstoffträger wird eine starke Mittenüberhöhung des Dotierstoffeinbaus beobachtet. Durch eine geeignete Wahl des Verhältnisses der Massenflüsse von $N_2$ und $NH_3$ beziehungsweise durch eine geeignete Wahl der vertikalen Höhenlage der Gaseinlasszonen, durch die die voneinander verschiedenen Dotierstoffträger in die Prozesskammer eingespeist werden, kann ein Dotierungsprofile erzeugt werden, die zu einer Kompensation der Mittenüberhöhung beziehungsweise Randüberhöhung führt.

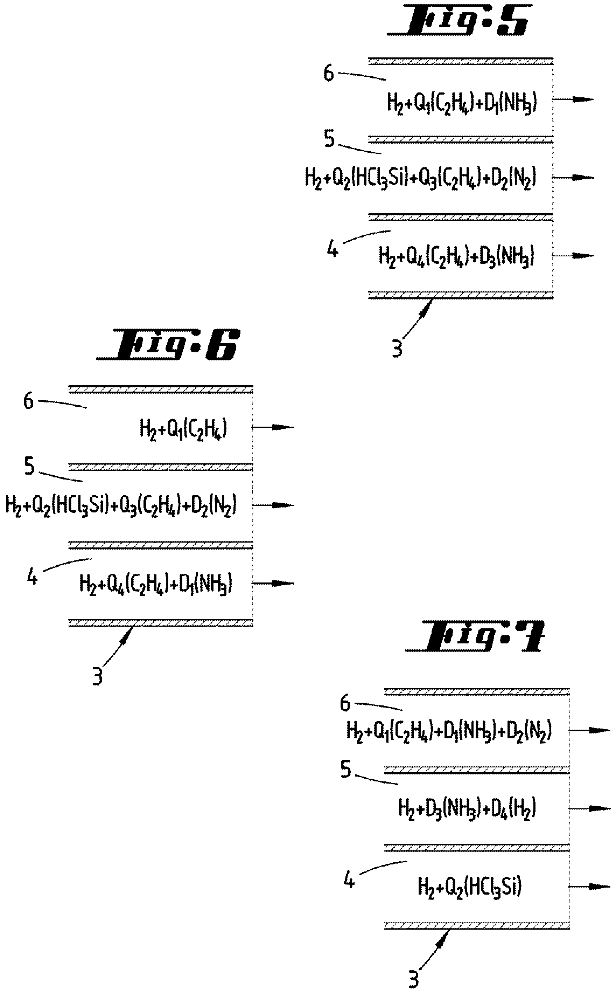

Bei dem in der Figur 5 dargestellten Ausführungsbeispiel wird anders als bei dem in der Figur 1 dargestellten Ausführungsbeispiel zusätzlich durch die zuunterst angeordnete Gaseinlasszone 4 ein dritter Dotiergasflusses D3 eingespeist, bei dem es sich um $NH_3$ handelt.

Bei dem in der Figur 6 dargestellten Ausführungsbeispiel wird durch die zuoberst angeordnete Gaseinlasszone 6 kein Dotiergasfluss in die Prozesskammer 2 eingespeist. Hier wird nur durch die zuunterst liegende Gaseinlasszone 4 ein erster Dotiergasfluss D1 ($NH_3$) und durch die mittlere beziehungsweise unmittelbar darüber liegende Gaseinlasszone ein zweiter Dotiergasfluss D2 ($N_2$) eingespeist.

Durch die Wahl der vertikal voneinander verschiedenen beziehungsweise beabstandeten Gaseinlasszonen 4, 6 kann die Form des Verlaufs der Verarmungskurven a, b eingestellt werden.

Bei dem in der Figur 7 dargestellten Ausführungsbeispiel werden durch zwei voneinander verschiedene Gaseinlasszonen 5, 6, bei denen es sich bevorzugt um obere Gaseinlasszonen handelt, jeweils zwei voneinander verschiedene Dotiergasflüsse D1, D2, D3, D4 in die Prozesskammer 2 eingespeist. Die Massenflüsse der durch die verschiedenen Gaseinlasszonen 5, 6 eingespeisten Dotiergasflüsse D1, D2, D3, D4 unterscheiden sich dann. Es kann vorgesehen sein, dass durch eine Gaseinlasszone 5, 6 ein Gasgemisch, das zwei voneinander verschiedene Dotierstoffträger aufweist, fließt. Das Gasgemisch kann jeweils aus $NH_3$ und $N_2$ bestehen. Der $NH_3$-Fluss durch die Gaseinlasszone 5 kann dabei verschieden sein vom $NH_3$-Fluss durch die Gaseinlasszone 6. Ebenso können sich die beiden $N_2$-Flüsse unterscheiden.

Durch die Einspeisung der Dotiergase verteilt auf verschiedene Einspeise-Niveaus ergibt sich die Möglichkeit, das Dotierprofil gezielt einzustellen. Hierzu kann beispielsweise das folgende Verfahren verwendet werden: Es wird zunächst eine dotierte Schicht abgeschieden, bei der nur ein $NH_3$-Fluss verwendet wird. Bei dieser Schicht wird das Dotierstoffprofil ermittelt. Es wird eine zweite Schicht auf einem zweiten Substrat abgeschieden, wobei als Dotierstoff nur ein $N_2$-Fluss verwendet wird. Alternativ dazu kann die zweite Schicht aber auch abgeschieden werden, indem gleichzeitig ein NH₃-Fluss und ein N₂-Fluss in die Prozesskammer eingespeist werden. An diesen Schichten wird wiederum das Dotierstoffprofil gemessen. Der NH₃-Fluss beziehungsweise N₂-Fluss wird dann beispielsweise in Modellrechnungen oder in weiteren Versuchen so lange angepasst/variiert, also erhöht oder vermindert, bis ein akzeptables "flaches" Dotierprofil erreicht ist.

Es wird als wesentlich angesehen, dass bei der Verwendung von NH₃ eine Gaseinlasszone 4 oder 6 verwendet wird, durch die kein chlorhaltiges Gasgemisch strömt. Es ist somit insbesondere vorgesehen, dass ein chlorhaltiger Wachstumsgasfluss ausschließlich durch eine mittlere Gaseinlasszone 5 in die Prozesskammer eingespeist wird.

Es kann vorgesehen sein, dass durch sämtliche Gaseinlasszonen 4, 5, 6 ein Gasfluss eines kohlenstoffhaltigen Wachstumsgases strömt.

Bei der Auswahl der Paarungen der Dotierstoffträger kann es vorteilhaft sein, wenn die Dotierstoffträger unterschiedliche Stickstoffbindungen (Einfach-, Zweifach- oder Dreifachbindungen) aufweisen, oder wenn die Dotierstoffe der Dotierstoffträger mit unterschiedlich starken chemischen Bindungen im Molekül des Dotierstoffträgers gebunden sind. Es ist davon auszugehen, dass sich diese Dotierstoffträger unterschiedlich zerlegen und somit voneinander verschiedene Verarmungskurven zeigen, sodass das Dotierstoffprofil innerhalb der abzuschneidenden Schicht einstellbar ist.

Es kann von Vorteil sein, wenn durch die zuoberst liegende und die zuunterst liegende Gaseinlasszone 4, 6 jeweils NH₃ eingespeist wird und durch die in der Mitte liegende Gaseinlasszone 5 N₂ eingespeist wird.

Das kohlenstoffhaltige Reaktionsgas, beispielsweise $C_2H_4$, wird bevorzugt in folgender Massenverteilung in die Prozesskammer 2 eingespeist: 10% jeweils durch die zuunterst und die zuoberst liegenden Gaseinlasszonen 4, 6 und 80% durch die mittlere Gaseinlasszone 5. Das Silizium enthaltende reaktive Gas, insbesondere Trichlorsilan oder Dichlorsilan, wird bevorzugt ausschließlich durch die mittlere Gaseinlasszone 5 in die Prozesskammer 2 eingespeist.

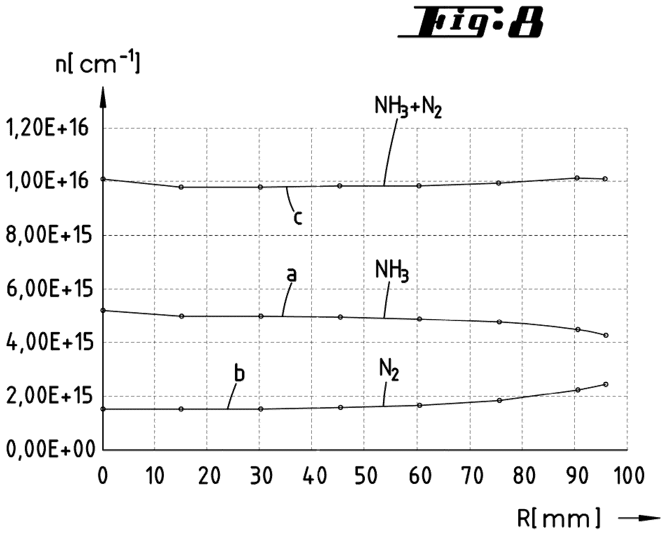

Die Figur 8 zeigt ein erstes laterales Dotierstoffprofil a, das in einer auf einem Substrat abgeschiedenen Schicht SiC gemessen worden ist. Bei dem Profil handelt es sich um die in der Schicht gemessene N-Konzentration in Abhängigkeit vom Abstand R zu einem Mittelpunkt des kreisförmigen Substrates. Beim Abscheiden der Schicht wurde nur NH₃ als Dotierstoffträger verwendet.

Die Wachstumsgasflüsse Q1, Q2 wurden dabei derart variiert, dass das Profil a möglichst flach verläuft.

Mit denselben Wachstumsgasflüssen Q1, Q2 wurde auf einem zweiten Substrat eine SiC-Schicht abgeschieden, wobei beim Abscheiden der Schicht nur N₂ als Dotierstoffträger verwendet wurde.

Die Kurve c zeigt ein berechnetes laterales Dotierstoffprofil der N-Konzentration in einer Schicht, wenn als Dotierstoffträger sowohl NH₃ als auch N₂ verwendet wird. Die Massenflüsse der Dotiergasflüsse D1', D2' wurden dabei derart optimiert, dass die Kurve c möglichst flach verläuft.

**Patentansprüche**

1. Verfahren zum Abscheiden einer SiC-Schicht auf einem Substrat (12) in einer mit einer Heizeinrichtung (14) auf eine Prozesstemperatur aufgeheizten Prozesskammer (2) eines CVD-Reaktors (1), wobei durch ein Gaseinlassorgan (3) ein Prozessgasfluss in die Prozesskammer (2) eingespeist wird und in einer Horizontalrichtung in einer Strömungsrichtung (S) über das drehangetriebene Substrat (12) fließt, wobei sich der Prozessgasfluss aus zumindest einem Dotiergasfluss (D1), der einen ersten gasförmigen Dotierstoffträger enthält, einem zweiten Dotiergasfluss (D2), der einen zweiten gasförmigen Dotierstoffträger enthält, einem Kohlenstoff enthaltenden ersten Wachstumsgasfluss (Q1) und einem Silizium enthaltenden zweiten Wachstumsgasfluss (Q2) zusammensetzt, wobei sich die Dotierstoffträger beim Durchströmen der Prozesskammer (2) in Zerlegungsprodukte zerlegen, wobei die Zerlegungsprodukte an der Oberfläche der auf dem Substrat aufwachsenden SiC-Schicht als Dotierstoff in die SiC-Schicht eingebaut werden und wobei die beiden Dotiergasflüsse (D1, D2) getrennt voneinander geregelt durch vertikal übereinander angeordnete Gaseinlasszonen (4, 5, 6) in die Prozesskammer (2) eingespeist werden, wobei jeder der beiden Dotiergasflüsse (D1, D2) ein laterales Profil (a, b) seines Dotierstoffs mit einem charakteristischen Flächenkrümmungsverlauf in einer SiC-Schicht erzeugt, **dadurch gekennzeichnet, dass** die Massenflüsse der ersten und zweiten Dotiergasflüsse (D1, D2) und/oder die vertikale Lage der Gaseinlasszonen (4, 5, 6), durch die die beiden Dotiergasflüsse (D1, D2) strömen, so gewählt sind, dass die lateralen Profile (a, b) voneinander verschiedene Flächenkrümmungsverläufe aufweisen.

2. Verfahren nach Anspruch 1, **dadurch gekennzeichnet, dass** der erste Dotierstoffträger ein Stickstoff enthaltendes Gas und insbesondere NH₃ und der zweite Dotierstoffträger ein Stickstoff enthaltendes Gas und insbesondere N₂ ist.

3. Verfahren nach einem der vorhergehenden Ansprüche, **dadurch gekennzeichnet, dass** die Bindungskräfte eines Stickstoffatoms an andere Atome des zweiten Dotierstoffträgers größer sind als die Bindungskräfte eines Stickstoffatoms an andere Atome des ersten Dotierstoffträgers.

4. Verfahren nach einem der vorhergehenden Ansprüche, **dadurch gekennzeichnet, dass** der zweite Wachstumsgasfluss (Q2) Chlor enthält und der erste Wachstumsgasfluss (Q1) nicht zusammen mit dem $NH_3$ enthaltenden ersten Dotiergasfluss (D1) durch dieselbe Gaseinlasszone (4, 5, 6) strömt.

5. Verfahren nach einem der vorhergehenden Ansprüche, **dadurch gekennzeichnet, dass** die ersten und zweiten Dotierstoffträger und die Massenflüsse der sie tragenden Dotiergasflüsse (D1, D2) derart gewählt sind, dass sich eine mit dem Verhältnis der Massenflüsse gewichtete Summe der beiden Profile (a, b) einer Ebene annähert.

6. Verfahren nach einem der vorhergehenden Ansprüche, **dadurch gekennzeichnet, dass** die Dotierstoffträger ausgewählt aus folgenden Stickstoffverbindungen sind: $N_2$, $NH_3$, HCN, Pyridin ($C_5H_5N$), Hydrazin ($N_2H_4$), Dimethylhydrazin ($C_2H_8N_2$) oder unsymmetrisches Dimethylhydrazin.

7. Verfahren nach einem der vorhergehenden Ansprüche, **dadurch gekennzeichnet, dass** der Prozessgasfluss in ein zentrales Gaseinlassorgan (3) eingespeist wird, das von kreisförmig um das Gaseinlassorgan (3) angeordneten Substrathaltern (11) umgeben ist, die in Taschen (17) eines Suszeptors (10) einliegen, wobei die Substrathalter (11) von einem Gaskissen getragen und drehangetrieben werden.

8. Verfahren nach einem der vorhergehenden Ansprüche, **dadurch gekennzeichnet, dass** der erste Dotiergasfluss (D1) durch eine zuoberst angeordnete Gaseinlasszone (6) und der zweite Dotiergasfluss (D2) durch eine tiefer liegende Gaseinlasszone (5) fließt und/oder dass der erste Dotiergasfluss (D1) zusammen mit dem ersten Wachstumsgasfluss (Q1) durch dieselbe Gaseinlasszone (6) fließt und/ oder dass der zweite Dotiergasfluss (D2) zusammen mit dem zweiten Wachstumsgasfluss (Q2) durch dieselbe Gaseinlasszone (5) fließt und/oder dass durch eine zuunterst angeordnete Gaseinlasszone (4) ein dritter Wachstumsgasfluss (Q3) fließt und durch die zuunterst angeordnete Gaseinlasszone (4) kein Dotiergasfluss fließt und/oder dass ein dritter Dotiergasfluss (D3) durch eine zuunterst angeordnete Gaseinlasszone (4) fließt und/oder dass der erste Dotiergasfluss (D1) durch eine zuunterst angeordnete Gaseinlasszone (4) fließt und der zweite Dotiergasfluss (D2) durch eine darüber liegende Gaseinlasszone (5) fließt und/oder dass der erste Dotiergasfluss (D1) und der zweite Dotiergasfluss (D2) denselben Dotierstoffträger beinhalten, wobei der erste Dotiergasfluss (D1) durch eine zuoberst angeordnete Gaseinlasszone (6) und der zweite Dotiergasfluss (D2) durch eine zuunterst angeordnete Gaseinlasszone (4) fließt und/oder dass durch eine Gaseinlasszone (6), insbesondere die zuoberst angeordnete Gaseinlasszone, oder durch zwei Gaseinlasszonen (5, 6), insbesondere durch oben angeordnete Gaseinlasszonen (5, 6) zwei voneinander verschiedene Dotiergasflüsse (D1, D2; D3, D4) in die Prozesskammer (2) eingespeist werden, wobei die durch eine gemeinsame Gaseinlasszone (5, 6) fließenden Dotiergasflüsse (D1, D2; D3, D4) voneinander verschiedene Dotierstoffträger aufweisen.

9. Vorrichtung mit einem CVD-Reaktor (1), der einen sich in einer Horizontalebene erstreckenden Suszeptor (10) zur Aufnahme von Substraten (12) und ein mehrere vertikal übereinander angeordnete Gaseinlasszonen (4, 5, 6) aufweisendes Gaseinlassorgan (3) aufweist, wobei die Gaseinlasszonen (4, 5, 6) mittels Zuleitungen (24, 25, 26) und in den Zuleitungen angeordneten Massenfluss-Controllern (21) und Ventilen (22) mit Gasquellen (27, 28, 29, 30) verbunden sind, in denen getrennt voneinander erste und zweite Dotierstoffträger sowie ein Kohlenstoff enthaltendes reaktives Gas und ein Silizium enthaltendes reaktives Gas bevorratet sind, und mit einer Steuereinrichtung (20) zur Steuerung der Massenfluss-Controller (21) und Ventile (22), **dadurch gekennzeichnet, dass** die Steuereinrichtung (20) eingerichtet ist zur Durchführung eines Verfahrens gemäß einem der vorhergehenden Ansprüche.

## Claims

1. Method for depositing a SiC layer on a substrate (12) in a process chamber (2) of a CVD reactor (1) heated to a process temperature by a heating device (14), wherein a process gas flow is fed into the process chamber (2) through a gas inlet device (3) and flows in a horizontal direction in a flow direction (S) over the rotationally driven substrate (12), wherein the process gas flow comprises at least one dopant gas flow (D1) which contains a first gaseous dopant carrier, a second dopant gas flow (D2) which contains a second gaseous dopant carrier, a carbon-containing first growth gas flow (Q1) and a silicon-containing second growth gas flow (Q2), wherein the dopant carriers decompose into decomposition products as they flow through the process chamber (2), the decomposition products being incorporated into the SiC layer as a dopant at the surface of the SiC layer growing on the substrate, and the two dopant gas flows (D1, D2) being fed into the process chamber (2) separately from each other in a controlled manner through gas inlet zones (4, 5, 6) arranged vertically one above the other, each of the two dopant gas flows (D1, D2) producing a lateral profile (a, b) of its dopant with a characteristic surface curvature in a SiC layer, **characterised in that** the mass flows of the first and second dopant gas flows (D1, D2) and/or the vertical position of the gas inlet zones (4, 5, 6) through which the two dopant gas flows (D1, D2) flow are selected such that the lateral profiles (a, b) have different curvatures.

2. Method according to claim 1, **characterised in that** the first dopant carrier is a nitrogen-containing gas, in particular $NH_3$ and , and the second dopant carrier is a nitrogen-containing gas, in particular $N_2$.

3. Method according to one of the preceding claims, **characterised in that** the binding forces of a nitrogen atom to other atoms of the second dopant carrier are greater than the binding forces of a nitrogen atom to other atoms of the first dopant carrier.

4. Method according to one of the preceding claims, **characterised in that** the second growth gas flow (Q2) contains chlorine and the first growth gas flow (Q1) does not flow together with the $NH_3$containing first dopant gas flow (D1) through the same gas inlet zone (4, 5, 6).

5. Method according to one of the preceding claims, **characterised in that** the first and second dopants and the mass flows of the dopant gas flows (D1, D2) carrying them are selected such that a sum of the two profiles (a, b) weighted by the ratio of the mass flows approximates a plane.

6. Method according to one of the preceding claims, **characterised in that** the dopant carriers are selected from the following nitrogen compounds: $N_2$ , $NH_3$ , HCN, pyridine ($C_5 H_5 N$), hydrazine ($N_2 H_4$ ), dimethylhydrazine ($C_2 H_8 N_2$) or unsymmetrical dimethylhydrazine.

7. Method according to one of the preceding claims, **characterised in that** the process gas flow is fed into a central gas inlet device (3) which is surrounded by substrate holders (11) arranged circularly around the gas inlet device (3) and which are located in pockets (17) of a susceptor (10), wherein the substrate holders (11) are supported by a gas cushion and are rotatably driven.

8. Method according to one of the preceding claims, **characterised in that** the first dopant gas flow (D1) flows through a gas inlet zone (6) arranged at the top and the second dopant gas flow (D2) flows through a gas inlet zone (6) located lower down (5) and/or that the first dopant gas flow (D1) flows together with the first growth gas flow (Q1) through the same gas inlet zone (6) and/or that the second dopant gas flow (D2) flows together with the second growth gas flow (Q2) through the same gas inlet zone (5) and/or that a third growth gas flow (Q3) flows through a gas inlet zone (4) arranged at the bottom and no dopant gas flow flows through the gas inlet zone (4) arranged at the bottom and/or that a third dopant gas flow (D3) flows through a gas inlet zone (4) arranged at the bottom (4) and/or that the first dopant gas flow (D1) flows through a gas inlet zone (4) arranged at the bottom and the second dopant gas flow (D2) flows through a gas inlet zone (5) located above it and/or that the first dopant gas flow (D1) and the second dopant gas flow (D2) contain the same dopant carrier, wherein the first dopant gas flow (D1) flows through a gas inlet zone (6) arranged at the top and the second dopant gas flow (D2) flows through a gas inlet zone (4) arranged at the bottom, and/or that a gas inlet zone (6), in particular the gas inlet zone arranged at the top, or through two gas inlet zones (5, 6), in particular through gas inlet zones (5, 6) arranged at the top, two different dopant gas flows (D1, D2; D3, D4) are fed into the process chamber (2), wherein the dopant gas flows (D1, D2; D3, D4) flowing through a common gas inlet zone (5, 6) have dopant carriers that are different from one another.

9. Apparatus comprising a CVD reactor (1) which has a susceptor (10) extending in a horizontal plane for receiving substrates (12) and a gas inlet member (3) having a plurality of gas inlet zones (4, 5, 6) arranged vertically one above the other (6) connected by means of supply lines (24, 25, 26) and mass flow controllers (21) and valves (22) arranged in the supply lines to gas sources (27, 28, 29, 30) in which first and second dopant carriers as well as a carbon-containing reactive gas and a silicon-containing reactive gas are stored separately from one another, and with a control device (20) for controlling the mass flow controllers (21) and valves (22), **characterised in that** the control device (20) is designed to carry out a method according to one of the preceding claims.

## Revendications

1. Procédé de dépôt d'une couche de carbure de silicium (SiC) sur un substrat (12) dans une chambre de processus (2) d'un réacteur de Dépôt Chimique en Phase Vapeur (DCPV) (1), chauffée à une température de processus avec un système de chauffage (14), sachant qu'un flux de gaz de processus est introduit dans la chambre de processus (2) par un organe d'entrée de gaz (3) et s'écoule dans une direction horizontale dans une direction d'écoulement (S) sur le substrat (12) entraîné en rotation, sachant que le flux de gaz de processus se compose d'au moins un flux de gaz dopant (D1), qui contient un premier porteur de substance dopante gazeux, un deuxième flux de gaz dopant (D2), qui contient un deuxième porteur de substance dopante gazeux, d'un premier flux de gaz de croissance (Q1) contenant du carbone et d'un deuxième flux de gaz de croissance (Q2) contenant du silicium, sachant que les porteurs de substance dopante se décomposent en produits de décomposition en traversant la chambre de processus (2), sachant que les produits de décomposition sont incorporés dans la couche de SiC en tant que substance dopante à la surface de la couche de SiC croissant sur le substrat et sachant que les deux flux de gaz dopant (D1, D2) sont introduits séparés l'un de l'autre, régulés dans la chambre de processus (2) par des zones d'entrée de gaz (4, 5, 6) disposées verticalement l'une sur l'autre, sachant que chacun des deux flux de gaz dopant (D1, D2) produit un profil latéral (a, b) de sa substance dopante avec un profil de courbure superficiel caractéristique dans une couche de SiC, **caractérisé en ce que** les débits massiques des premiers et deuxièmes flux de gaz dopant (D1, D2) et/ou la position verticale des zones d'entrée de gaz (4, 5, 6) à travers lesquelles les deux flux de gaz dopant (D1, D2) s'écoulent, sont choisis de telle manière que les profils latéraux (a, b) comportent des profils de courbure superficiels différents l'un de l'autre.

2. Procédé selon la revendication 1, **caractérisé en ce que** le premier porteur de substance dopante est un gaz contenant de l'azote et en particulier du $NH_3$ et le deuxième porteur de substance dopante est un gaz contenant de l'azote et en particulier du $N_2$.

3. Procédé selon l'une quelconque des revendications précédentes, **caractérisé en ce que** les forces de liaison d'un atome d'azote à d'autres atomes du deuxième porteur de substance dopante sont plus grandes que les forces de liaison d'un atome d'azote à d'autres atomes du premier porteur de substance dopante.

4. Procédé selon l'une quelconque des revendications précédentes, **caractérisé en ce que** le deuxième flux de gaz de croissance (Q2) contient du chlore et le premier flux de gaz de croissance (Q1) ne s'écoule pas ensemble avec le premier flux de gaz dopant (D1) contenant du $NH_3$ à travers la même zone d'entrée de gaz (4, 5, 6).

5. Procédé selon l'une quelconque des revendications précédentes, **caractérisé en ce que** le premier et le deuxième flux de gaz dopant et les débits massiques des flux de gaz dopant (D1, D2) les portant, sont choisis de telle manière qu'un total des deux profils (a, b) pondéré par rapport aux débits massiques se rapproche d'un plan.

6. Procédé selon l'une quelconque des revendications précédentes, **caractérisé en ce que** les porteurs de substance dopante sont choisis à partir des composés azotés suivants : $N_2$, $NH_3$, HCN, pyridine ($C_5H_5N$), hydrazine ($N_2H_4$), diméthylhydrazine ($C_2H_8N_2$) ou diméthylhydrazine asymétrique.

7. Procédé selon l'une quelconque des revendications précédentes, **caractérisé en ce que** le flux de gaz de processus est introduit dans un organe d'entrée de gaz (3) central, qui est entouré par des supports de substrat (11) disposés de façon circulaire autour de l'organe d'entrée de gaz (3), qui sont inclus dans des poches (17) d'un suscepteur (10), sachant que les supports de substrat (11) sont portés et entraînés en rotation par un coussin de gaz.

8. Procédé selon l'une quelconque des revendications précédentes, **caractérisé en ce que** le premier flux de gaz dopant (D1) s'écoule à travers une zone d'entrée de gaz (6) disposée tout en haut et le deuxième flux de gaz dopant (D2) s'écoule à travers une zone d'entrée de gaz (5) située plus profonde et/ou **en ce que** le premier flux de gaz dopant (D1) s'écoule ensemble avec le premier flux de gaz de croissance (Q1) à travers la même zone d'entrée de gaz (6) et/ou **en ce que** le deuxième flux de gaz dopant (D2) s'écoule ensemble avec le deuxième flux de gaz de croissance (Q2) à travers la même zone d'entrée de gaz (5) et/ou **en ce qu'**un troisième flux de gaz de croissance (Q3) s'écoule à travers une zone d'entrée de gaz (4) disposée tout en bas et aucun flux de gaz dopant ne s'écoule à travers la zone d'entrée de gaz (4) disposée tout en bas et/ou **en ce qu'**un troisième flux de gaz dopant (D3) s'écoule à travers une zone d'entrée de gaz (4) disposée tout en bas et/ou **en ce que** le premier flux de gaz dopant (D1) s'écoule à travers une zone d'entrée de gaz (4) disposée tout en bas et le deuxième flux de gaz dopant (D2) s'écoule à travers une zone d'entrée de gaz (5) située au-dessus et/ou **en ce que** le premier flux de gaz dopant (D1) et le deuxième flux de gaz dopant (D2) contiennent le même porteur de substance dopante, sachant que le premier flux de gaz dopant (D1) s'écoule à travers une zone d'entrée de gaz (6) disposée tout en haut et le deuxième flux de gaz dopant (D2) s'écoule à travers une zone d'entrée de gaz (4) disposée tout en bas et/ou **en ce que** deux flux de gaz dopant (D1, D2, D3, D4) différents l'un de l'autre sont introduits dans la chambre de processus (2) à travers une zone d'entrée de gaz (6), en particulier la zone d'entrée de gaz disposée tout en haut, ou à travers deux zones d'entrée de gaz (5, 6), en particulier à travers les zones d'entrée de gaz (5, 6) disposées en haut, sachant que les flux de gaz dopant (D1, D2, D3, D4) s'écoulant à travers une zone d'entrée de gaz (5, 6) commune comportent des porteurs de substance dopante différents l'un de l'autre.

9. Dispositif avec un réacteur de dépôt chimique en phase vapeur (DCPV) (1), qui comporte un suscepteur (10) s'étendant dans un plan horizontal pour recevoir des substrats (12) et un organe d'entrée de gaz (3) comportant plusieurs zones d'entrée de gaz (4, 5, 6) disposées verticalement les unes sur les autres, sachant que les zones d'entrée de gaz (4, 5, 6) sont reliées à des sources de gaz (27, 28, 29, 30) au moyen de conduits d'alimentation (24, 25, 26) et de régulateurs de débit massique (21) disposés dans les conduits d'alimentation et de soupapes (22), dans lesquels sont stockés séparés les uns des autres les premiers et deuxièmes porteurs de substance dopante ainsi qu'un gaz réactif contenant du carbone et un gaz réactif contenant du silicium et avec un système de commande (20) pour commander les régulateurs de débit massique (21) et les soupapes (22), **caractérisé en ce que** le système de commande (20) est agencé pour exécuter un procédé selon l'une quelconque des revendications précédentes.

Fig·1

$H_2+Q_1(C_2H_4)+D_1(NH_3)$

$H_2+Q_2(HCl_3Si)+Q_3(C_2H_4)+D_2(N_2)$

$H_2+Q_4(C_2H_4)$

Fig·2

Fig. 3

Fig. 4

## Fig. 5

6 — 

$H_2+Q_1(C_2H_4)+D_1(NH_3)$ →

5 —

$H_2+Q_2(HCl_3Si)+Q_3(C_2H_4)+D_2(N_2)$ →

4 — $H_2+Q_4(C_2H_4)+D_3(NH_3)$ →

3

## Fig. 6

6 —

$H_2+Q_1(C_2H_4)$ →

5 —

$H_2+Q_2(HCl_3Si)+Q_3(C_2H_4)+D_2(N_2)$ →

4 — $H_2+Q_4(C_2H_4)+D_1(NH_3)$ →

3

## Fig. 7

6 —

$H_2+Q_1(C_2H_4)+D_1(NH_3)+D_2(N_2)$ →

5 —

$H_2+D_3(NH_3)+D_4(H_2)$ →

4 — $H_2+Q_2(HCl_3Si)$ →

3

15

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011054566 A1
- US 20200043725 A1
- US 20160348274 A1

- JP 2015143168 A
- WO 2022053963 A1

**In der Beschreibung aufgeführte Nicht-Patentliteratur**

- **MARIO BENES et al.** Experimental Study of the Pyrolysis of NH3 under Flow Reactor Conditions. American Chemical Society, 2021, 7193